Europäisches Patentamt

European Patent Office

Office européen des brevets

(11) Numéro de publication: **0 068 926**
A1

## (12) DEMANDE DE BREVET EUROPEEN

(21) Numéro de dépôt: 82400982.3

(22) Date de dépôt: 27.05.82

(51) Int. Cl.³: **H 03 H 9/10, H 05 K 13/02**

(30) Priorité: 05.06.81 FR 8111217

(43) Date de publication de la demande: 05.01.83
Bulletin 83/1

(84) Etats contractants désignés: **DE GB NL**

(71) Demandeur: **COMPAGNIE D'ELECTRONIQUE ET DE
PIEZO-ELECTRICITE - C.E.P.E., 101, rue du Président
Roosevelt, F-78500 Sartrouville (FR)**

(72) Inventeur: **Beraud, Henri, THOMSON-CSF SCPI 173, bld
Haussmann, F-75379 Paris Cedex 08 (FR)**

(74) Mandataire: **Jacquard, Philippe et al, THOMSON-CSF
SCPI 173, Bld Haussmann, F-75379 Paris Cedex 08 (FR)**

(54) **Plot de maintien de broches d'une embase, et son utilisation pour le maintien de ladite embase.**

(57) Plot (1) pour embase (2) traversée par n mats (51, 52,
...) avec n ≥ 1, les parties supérieures ou poteaux étant
destinées à brancher un circuit, les parties inférieures ou
broches (a, b, ...) étant disposées en saillie. Selon l'invention, le plot (1) comporte n dispositifs de maintien (31, 32,
...) destinés à la fixation des broches (a, b, ...) de l'embase (2) dans celui-ci, séparés par un ou plusieurs bossages
(3) qui permettent d'accéder au moins à une broche (a, b,
...) entre l'embase (2) et le dispositif de maintien (31, 32,
...) correspondant.

## PLOT DE MAINTIEN DE BROCHES D'UNE EMBASE
## ET SON UTILISATION POUR LE MAINTIEN
## DE LADITE EMBASE

La présente invention concerne un plot pour embase traversée par n mats avec $n \geqslant 1$, les parties supérieures ou poteaux desdits mats étant destinées à la connexion d'un circuit, les parties inférieures ou broches étant disposées en saillie.

De tels plots sont utilisés, par exemple, pour rendre plus aisée la manipulation d'une embase d'un pilote à quartz aux différents stades de son encapsulation. La fabrication de ce type de matériel nécessite plusieurs opérations et plusieurs déplacements de l'embase du pilote. Toutes ces opérations détériorent les broches par pliage, ce qui pose ensuite des problèmes pour les enfiler sur les machines et sur les postes de contrôle et la nécessité d'effectuer un redressage manuel des broches, ce qui entraîne une perte de temps. De plus, l'embase utilisée pour lesdits pilotes comporte des perles d'étanchéité. Ces perles sont fragiles et sensibles à toute traction sur les broches. Aussi, le plot doit-il être conçu pour éviter ces tractions tant à la pose du plot sur l'embase que durant la présence du plot sur l'embase et la dissociation du plot de l'embase. Enfin, des mesures électriques étant faites sur un certain nombre de broches de l'embase en cours de fabrication des pilotes, la structure du plot doit permettre une bonne accessibilité auxdites broches.

Il a déjà été proposé d'utiliser un plot pour embase servant au branchement électrique d'un élément sur un circuit. Un tel plot est constitué d'une armature cylindrique ou parallélépipédique et isolante électriquement, comportant n trous cylindriques traversant l'armature depuis sa face inférieure jusqu'à sa face supérieure. Des ressorts sont prévus pour faire pression sur la section desdits trous et donc sur les broches de ladite embase afin que le plot reste accroché à l'embase. Pour prendre une mesure sur lesdites broches, la sonde vient au contact des ressorts. Toutefois, un tel plot présente l'inconvénient de provoquer de fortes tractions dues aux ressorts, lors de la pose dudit plot sur l'embase et de la dissociation dudit plot de son embase. De plus, la mesure par l'intermédiaire des ressorts est à l'origine d'impédances parasites perturbant sa valeur. En outre, un tel plot ne comporte aucun dispositif permettant l'introduction aisée d'un grand nombre de broches dans lesdits trous.

Si un tel plot évite le pliage des broches, il ne possède que peu des qualités souhaitées pour ce type de plot. La première qualité désirée est la possibilité d'effectuer des mesures directement sur les broches sans intermédiaire de structure dudit plot. D'autre part, il est important que l'introduction des broches dans le plot s'effectue sans difficulté. Par ailleurs, il est nécessaire que la structure du plot soit telle qu'un nettoyage et un dégazage efficaces puissent être réalisés : ces opérations s'effectuant généralement dans une machine de nettoyage à ultra-sons, les bulles d'air décrochant les poussières ainsi que les produits de nettoyage utilisés doivent pouvoir circuler facilement. Enfin, on désire que la taille dudit plot soit réduite pour adapter ladite embase aux machines de traitement des circuits portés par celle-ci.

Le plot de maintien selon l'invention répond au problème posé et permet d'éviter les inconvénients de l'art antérieur. Dans ce but, il est caractérisée en ce qu'il comporte n dispositifs de maintien destinés à la fixation des broches de l'embase dans ledit plot, séparés par un ou plusieurs bossages qui permettent d'accéder au moins à une broche entre l'embase et le dispositif de maintien correspondant. Ainsi, la présente invention est destinée à maintenir les broches dans leur position, tout en permettant une mesure directe sur lesdites broches. En effet, les bossages laissent un espace entre lesdites broches et le milieu ambiant. Ledit espace permet de glisser une ou plusieurs sondes en contact direct avec les broches, afin d'effectuer des mesures sans élément intermédiaire de structure dudit plot.

Il est à noter qu'est compris dans le domaine de l'invention, le

3

cas où le plot est constitué premièrement d'un corps principal, deuxièmement des bossages disposés sur la face supérieure dudit corps et troisièmement d'une pièce posée sur les bossages et dans laquelle sont introduites lesdites broches qui viennent ensuite se loger dans le corps principal du plot. Néanmoins et plus fonctionnellement, lesdits bossages sont disposés sur la face supérieure dudit plot, c'est à dire la face la plus proche de l'embase. Ainsi, le contact de la sonde de mesure sur lesdites broches est situé aux points les plus proches de l'embase, évitant les impédances réactives parasites dues à la longueur des broches. La forme desdits bossages peut être cylindrique avec une face supérieure usinée, afin de permettre un bon contact avec l'embase, c'est-à-dire que les bossages ont un sommet plan sur lequel vient s'appuyer l'embase. La présente invention sera réalisée, de préférence, avec un seul bossage situé au centre des dispositifs de maintien, afin d'avoir accès à toutes les broches par la périphérie sans gêne du ou des autres bossages.

Selon un mode préférentiel de réalisation, la présente invention est caractérisée en ce que les bossages sont de forme conique. En effet, les broches des embases au moment de la fixation des plots sur ladite embase, sont généralement droites, mais convergentes. Le cône des bossages servira, alors, à les écarter. Si, de plus, le plot ne possède qu'un seul bossage situé au centre des n dispositifs de maintien, lesquels sont disposés sur le pourtour de la base du cône, les n broches pourront, après s'être écartées, être fixées directement sur les n dispositifs de maintien.

Le bossage central est donc préférentiellement constitué d'une part d'un tronc conique, d'autre part d'un sommet plan de section circulaire et enfin d'une base polygonale et plus particulièrement carrée autour de laquelle sont placés les trous cylindriques, c'est-à-dire que depuis ladite base polygonale, des méplats s'élèvent parallèlement auxdits trous cylindriques, la jonction entre le tronc conique et chacun des méplats étant une hyperbole.

Selon un autre mode préférentiel de réalisation, la présente invention est caractérisée en ce que les n dispositifs de maintien sont des trous cylindriques perpendiculaires au plan dudit sommet, ayant une section égale ou supérieure à la section desdites broches et dont les distances entre deux trous sont les mêmes que les distances broches à broches de ladite embase. Lesdits trous cylindriques traversent le plot depuis la face supérieure jusqu'à la face opposée dudit plot ou face inférieure. Les broches des embases considérées habituellement ayant la forme cylindrique, lesdits trous ont la forme cylindrique. De plus, lesdites broches étant perpendiculaires à ladite embase, au moins à leur sortie de ladite embase, lesdits trous cylindriques seront disposés perpendiculairement au plan du sommet desdits bossages. Ainsi, la disposition des trous cylindriques est conçue afin de garder la forme et la position originales des broches. De plus, pour faciliter l'introduction des broches, les trous cylindriques comportent un chanfrein à leur extrémité supérieure. Il est également possible que les trous cylindriques aient une section largement plus grande que la section des broches c'est-à-dire supérieure ou égale à deux fois la section de celles-ci. Cette particularité de l'invention permet aussi un nettoyage efficace desdites broches par procédé ultra-sons, les poussières ne restant pas coincées entre la broche et son dispositif de maintien et les produits de nettoyage pouvant circuler facilement.

Préférentiellement, les extrémités supérieures des dispositifs de maintien sont disposées en paliers, placés en escalier. Ainsi, ces extrémités supérieures ne sont pas toutes au même niveau. Aussi, comme la longueur des broches de ladite embase est sensiblement la même, seules les broches correspondant aux extrémités supérieures desdits trous d'un même palier s'introduiront simultanément dans le plot lors de la descente de l'embase sur le plot au moment de sa fixation. En fait, chacun des paliers peut comprendre une rangée de trous cylindriques ou bien un seul trou cylindrique. En effet, les embases auxquelles sont destinés les plots sont munies de broches disposées en polygone et même le plus souvent en carré. Aussi, lesdits trous cylindriques sont disposés par rangées successives qui constituent un polygone et plus particulièrement un carré, l'écar-

5

tement entre deux trous successifs étant le même qu'entre deux broches successives de ladite embase ce qui évitent la déformation desdites broches.

Pratiquement, on limite le nombre desdits trous cylindriques d'un même palier à 4 ou 5. Ainsi, lors de l'introduction de l'embase sur le plot, seules 4 ou 5 broches s'introduisent simultanément, ce qu'elles font d'autant plus facilement que les trous sont alignés en rangées. Il est à noter que toute surface reliant deux paliers peut avoir une forme quelconque et en particulier qu'est contenu dans l'invention le cas où chaque palier ne comportant qu'un seul trou cylindrique, les extrémités supérieures desdits trous sont disposées en hélice.

Les dimensions d'une section du plot perpendiculairement aux trous sont de préférence inférieures aux dimensions de l'embase dans un plan perpendiculaire aux broches. Lorsque le circuit à brancher sur les poteaux doit être recouvert d'un capot, il est commode de fixer celui-ci sur l'embase par soudure électrique. Or, les électrodes effectuant la soudure sont, le plus souvent, parallèles auxdites broches et viennent s'appliquer sur le pourtour de l'embase. Aussi, une telle structure dudit plot permet l'opération de soudure d'un capot, le plot restant sur les broches pendant l'opération. En fait, ladite soudure peut être également une soudure à froid sous forte pression ou tout autre moyen de collage sur ladite collerette, celle-ci émergeant du corps de ladite embase.

Le plot a, également, de préférence, une base cubique c'est-à-dire qu'il comporte des côtés plans parallèles aux broches. Cette particularité s'applique aux plots devant s'adapter à des glissières maintenant lesdits plots pendant que des opérations de fabrication ou de traitement sont en cours sur les embases supportées par lesdits plots.

Pour permettre la circulation d'un agent nettoyant ladite embase et pour faciliter la séparation de l'embase et du plot, celui-ci comportera en son centre une cavité cylindrique le traversant parallèlement aux trous cylindriques. L'introduction d'un objet dans ladite cavité cylindrique permet de repousser l'embase depuis le plot.

Le plot est généralement fabriqué à partir d'un matériau résistant aux températures comprises entre - 40°C et + 200°C et résistant aux produits de nettoyage connus de l'homme de l'art. En effet, l'embase est nettoyée et dégazée, le vide étant nécessaire autour du pilote complet. Ces opérations nécessitent tenue en température entre - 40°C et + 200°C et résistance à certains agents de nettoyage comme les acides, les alcools, le bifluorure d'ammonium, etc...

Il est à noter que les parties inférieures desdits mats sont appelées broches, mais qu'elles peuvent être aussi bien des broches que des fils.

La présente invention sera mieux comprise à l'aide de la description donnée à titre non limitatif, conjointement aux figures qui représentent :

- la figure 1, un plot pour embase selon l'invention muni de son embase,

- la figure 2, l'opération de soudure d'un capot sur une embase supportée par le plot de l'invention.

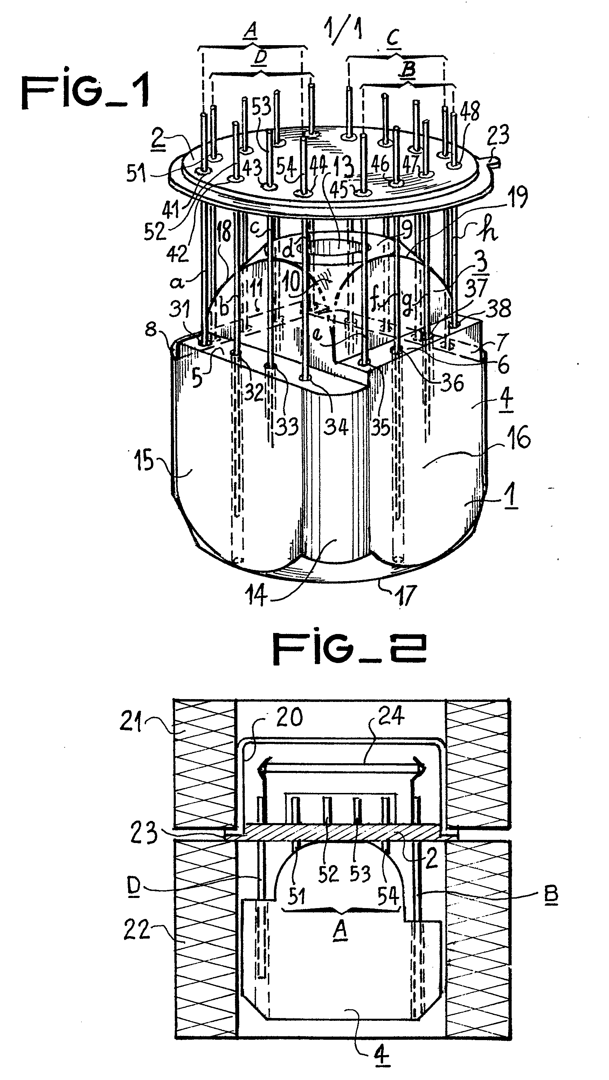

La figure 1 représente le plot (1) de l'invention muni de son embase (2), vu en perspective. Le plot (1) comporte une base cubique (4) dont les côtés (15, 16) sont verticaux, dont la face inférieure (17) est plane et horizontale afin de pouvoir poser le plot (1) et dont les arêtes (14) sont arrondies. Sur la face supérieure de la base cubique (4), est disposé un bossage (3) comportant un tronc conique (10), une base carrée d'où s'élèvent quatre méplats (11, 12) qui forment par intersection avec le tronc conique (10) quatre hyperboles (18, 19) et une partie supérieure (9) plane, horizontale et circulaire. Chacun des méplats (11, 12) est parallèle respectivement à chacun des côtés (15, 16) de la base (4). La distance entre deux côtés opposés de la base cubique (4) est supérieure à la distance entre deux méplats opposés du bossage (3) de telle sorte que quatre paliers (5, 6, 7, 8) horizontaux sont formés sur la face supérieure de la base cubique (4). Les quatre paliers (5, 6, 7, 8) sont disposés en escalier. Sur chacun des paliers (5, 6, 7, 8), quatre trous cylindriques (31, 32, 33, 34 et 35, 36, 37, 38) sont percés verticalement jusqu'à la face inférieure (17), et sont de taille égale entre eux. Le diamètre de chacun des trous est sensiblement le double de celui des broches de l'embase (2) et la distance entre deux trous cylindriques successifs est égale à la distance entre deux broches successives et de préférence comprise entre 1 mm et 3 mm. Une cavité cylindrique (13) traverse le plot (1) depuis la face supérieure (9) du bossage (3) jusqu'à la face inférieure (17), au centre du plot et parallèlement aux côtés (15, 16). L'embase (2) est horizontale et comporte 16 mats disposés en 4 séries (A, B, C, D) de 4 mats verticaux (51, 52, 53, 54) alignés, chacune des séries (A, B, C, D) représentant un côté du carré formé par les 16 mats. Chacun des mats (51, 52, 53, 54) comportent une partie supérieure ou poteau, une broche (a, b, c, d, et e, f, g, h) et une perle de verre (41, 42, 43, 44) située au niveau de l'embase (2) et isolant électriquement les mats (51, 52, 53, 54) de l'embase (2). Une collerette (23) est disposée autour de l'embase (2).

Afin de fixer l'embase (2) sur le plot (1), on descend progressivement l'embase (2) sur le bossage (3) qui écarte les broches (a, b, c, d, e, f, g, h) grâce à son tronc conique (10). En effet, les broches (a, b, c, d, e, f, g, h) sont droites mais légèrement convergentes aussi, il est nécessaire de les écarter l'une de l'autre. Cette première manipulation amène les quatre premières extrémités inférieures des broches (e, f, g, h) en face de chacun des quatre premiers trous cylindriques (35, 36, 37, 38) situés sur le palier le plus haut. On introduit alors simultanément dans le plot (1) les quatre broches (e, f, g, h) correspondant aux trous cylindriques (35, 36, 37, 38) du même palier (5). On continue, ensuite, à descendre l'embase (2) sur le plot (1) de façon que les quatre broches (a, b, c, d) suivantes se trouvent en face des trous cylindriques correspondants (31, 32, 33, 34) et ainsi de suite jusqu'à ce que les 16 broches soient introduites dans le plot (1). De cette manière, il est possible d'introduire les broches (a, b, c, d, e, f, g, h) quatre par quatre et non toutes les seize en même temps ce qui est une opération difficile.

Il est à noter que les trous cylindriques sont de diamètre double de celui des diamètres des broches afin que les broches s'introduisent facilement dans les trous cylindriques. De même, les trous cylindriques adoptent la même forme et le même espacement que les broches afin d'éviter toute traction sur les perles de verre.

Lorsque l'embase (2) est fixée sur le plot (1), sa face inférieure plane et horizontale vient s'appuyer sur la face supérieure (9) du bossage (3) plane et horizontale. Les broches sont alors accessibles sur une hauteur égale à celle du méplat (11, 12) correspondant au palier où elles sont introduites.

La cavité (34) sert à l'éjection de l'embase (2) du plot (1).

La figure 2 représente l'opération de soudure d'un capot sur une embase munie du plot de l'invention. Les mêmes éléments que ceux de la figure précédente portent les mêmes références. Lorsque l'embase (2) supporte par exemple un pilote à quartz (24), l'embase (2) doit être recouverte d'un capot (20) protégeant ledit pilote de l'atmosphère ambiante et permettant de réaliser le vide autour dudit pilote. Les électrodes de soudure (21) et (22) sont, alors, parallèles aux trous cylindriques (31, 32, 33, 34) et doivent venir effectuer la soudure sur le contour circulaire de l'embase (2) et plus précisément sur la collerette (23) de l'embase (2). Aussi, afin de garder l'embase (2) sur le plot (1) durant l'opération de soudure, il est nécessaire que la diagonale de la section carrée de la base (4) du plot (1) soit inférieure au diamètre intérieur de l'électrode (22).

# REVENDICATIONS

1. Plot (1) pour embase (2), laquelle comporte n mats (51, 52, ...) avec $n \geqslant 1$ traversant ladite embase, les parties supérieures desdits mats ou poteaux étant destinées à brancher un circuit, les parties inférieures desdits mats ou broches (a, b, ...) étant disposées en saillie, caractérisé en ce qu'il comporte n dispositifs de maintien (31, 32, ...) destinés à la fixation des broches (a, b, ...) de l'embase (2) dans celui-ci, séparés par un ou plusieurs bossages (3) qui permettent d'accéder au moins à une broche (a, b, ...) entre l'embase (2) et le dispositif de maintien (31, 32, ...) correspondant.

2. Plot pour embase selon la revendication 1, caractérisé en ce que les bossages (3) sont de forme conique.

3. Plot pour embase selon l'une des revendications 1 ou 2, caractérisé en ce que les bossages (3) ont un sommet plan (9) sur lequel vient s'appuyer l'embase (2).

4. Plot pour embase selon l'une des revendications 1 à 3, caractérisé en ce que le plot comporte un seul bossage (3) situé au centre des dispositifs de maintien (31, 32, ...).

5. Plot pour embase selon la revendication 4, caractérisé en ce que les bossages (3) ont une base dont le contour est un polygone.

6. Plot pour embase selon la revendication 4, caractérisé en ce que les bossages (3) ont une base dont le contour est un carré.

7. Plot pour embase selon l'une des revendications 1 à 6, caractérisé en ce que les n dispositifs de maintien sont des trous cylindriques perpendiculaires au plan (11), ayant une section égale ou supérieure à la section des broches, et dont les distances entre deux trous sont les mêmes que les distances broches à broches de l'embase (2).

8. Plot pour embase selon la revendication 7, caractérisé en ce que les trous cylindriques (31, 32, ...) ont une section supérieure ou égale à 2 fois la section des broches.

9. Plot pour embase selon la revendication 7, caractérisé en ce que les trous cylindriques comportent un chanfrein à leur extrémité supérieure.

10. Plot pour embase selon l'une des revendications 7 à 9, caractérisé en ce que lesdites extrêmités supérieures sont disposées en palier (5, 6, 7, 8).

11. Plot pour embase selon la revendication 10, caractérisé en ce que les paliers (5, 6, 7, 8) sont en escalier.

12. Plot pour embase selon l'une des revendications 1 à 11, caractérisé en ce que les dimensions d'une section du plot (1) perpendiculairement aux broches (a, b, ...) sont inférieures aux dimensions de la collerette (23) de l'embase (2), permettant d'introduire ledit plot dans une électrode. de soudure (21, 22) sur laquelle vient s'appuyer la collerette (23).

13. Plot pour embase selon l'une des revendications 1 à 12, caractérisé en ce que le plot est de base (4) cubique.

14. Plot pour embase selon l'une des revendications 1 à 13, caractérisé en ce qu'en son centre une cavité cylindrique (13) traverse le plot (1) parallèlement aux dispositifs de maintien (31, 32, ...).

15. Utilisation dudit plot pour le maintien d'une embase par ses broches.

FIG_1

0068926

1/1

FIG_2

0068926

Office européen
des brevets

**RAPPORT DE RECHERCHE EUROPEENNE**

Numéro de la demande

EP 82 40 0982

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | US-A-3 664 016 (LITTON SYSTEMS) * Colonne 2, ligne 64 - colonne 6, ligne 17; figures 1-4 * | 1,9 | H 03 H 9/10 H 05 K 13/02 |
| A | IBM TECHNICAL DISCLOSURE BULLETIN, vol. 13, no. 6, novembre 1970, page 1492, New York, USA J.V. IANNUCCI: "Pin alignement fixture" * Page 1942, texte et figure * | 1 | |
| A | FR-A-1 265 445 (PHILIPS) * Résumé; figures * | 1 | |

---

**DOMAINES TECHNIQUES RECHERCHES (Int. Cl. ³)**

H 05 K
H 03 H
H 01 R

Le présent rapport de recherche a été établi pour toutes les revendications

| Lieu de la recherche | Date d'achèvement de la recherche | Examinateur |
|---|---|---|
| LA HAYE | 08-09-1982 | GORUN M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&  : membre de la même famille, document correspondant

OEB Form 1503. 03.82